(19) Europäisches Patentamt / European Patent Office / Office européen des brevets

(11) **EP 2 930 519 B1**

(12) **FASCICULE DE BREVET EUROPEEN**

(45) Date de publication et mention
de la délivrance du brevet:
**01.11.2017 Bulletin 2017/44**

(51) Int Cl.:
***G01R 21/133*** *(2006.01)*

(21) Numéro de dépôt: **15163112.4**

(22) Date de dépôt: **10.04.2015**

(54) **PROCÉDÉ DE GESTION D'OPÉRATIONS DE COMPTAGE D'ÉNERGIE ACTIVE ET D'OPÉRATIONS DE COMPTAGE D'ÉNERGIE RÉACTIVE**

VERFAHREN ZUR STEUERUNG DER MESSUNG DES REALTEILS UND DES IMAGINÄRTEILS DER ENERGIE

METHOD FOR MANAGING ACTIVE POWER METERING OPERATIONS AND REACTIVE POWER METERING OPERATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.04.2014 FR 1453235**

(43) Date de publication de la demande:
**14.10.2015 Bulletin 2015/42**

(73) Titulaire: **SAGEMCOM ENERGY & TELECOM SAS 92500 Rueil-Malmaison (FR)**

(72) Inventeurs:
• **Teboulle, Henri**
 **92500 Rueil Malmaison (FR)**
• **Jourdan, René**
 **92500 Rueil Malmaison (FR)**

(74) Mandataire: **Le Guen-Maillet**
 **5, place de Newquay**
 **BP 70250**
 **35802 Dinard Cedex (FR)**

(56) Documents cités:
**EP-A1- 2 456 043     FR-A1- 2 589 581
JP-A- 2008 278 700**

• **LEE SEUNGWOO ET AL: "Automatic Standby Power Management Using Usage Profiling and Prediction", IEEE TRANSACTIONS ON HUMAN-MACHINE SYSTEMS, IEEE, PISCATAWAY, NJ, USA, vol. 43, no. 6, 1 novembre 2013 (2013-11-01), pages 535-546, XP011532508, ISSN: 2168-2291, DOI: 10.1109/THMS.2013.2285921 [extrait le 2013-11-25]**

## Description

La présente invention concerne une gestion d'activation et de désactivation d'opérations de comptage d'énergie active et d'opérations de comptage d'énergie réactive par un compteur électrique.

De nos jours, un compteur électrique destiné à superviser une installation électrique en termes de consommation énergétique s'appuie sur des seuils de courant pour déclencher des opérations de comptage d'énergie active et des opérations de comptage d'énergie réactive. Il est continuellement souhaitable d'améliorer la précision de mesure de tels compteurs électriques. Or, les mesures de courant effectuées par ces compteurs électriques pour déclencher les opérations de comptage d'énergie active et les opérations de comptage d'énergie réactive sont bruitées, ce qui entraîne des imprécisions dans le résultat des opérations de comptage d'énergie active et des opérations de comptage d'énergie réactive. Un tel bruit est intrinsèque au compteur électrique et est bien entendu particulièrement non négligeable lorsque les courants à mesurer sont faibles, *e.g.* de l'ordre de 5 mA. Un tel bruit va donc entraîner des activations et désactivations intempestives des opérations de comptage d'énergie active et des opérations de comptage d'énergie réactive, ce qui nuit à la précision du résultat des opérations de comptage.

Le document, FR 2 589 581 A1 divulgue un dispositif relais apte à déclencher un disjoncteur en fonction d'une comparaison d'une énergie moyenne consommée dans une installation électrique avec un seuil sélectionné parmi un premier et un second seuil en fonction de conditions d'utilisation du relais. L'article de Lee Seungwoo et al., "Automatic Standby Power Management Using Usage Profiling and Prediction" (IEEE Transactions on Human-Machine Systems, vol. 43, no. 6, 1 novembre 2013, pages 535-546) divulgue un procédé de gestion de l'alimentation consommée pendant stand-by, basé en une prédiction future d'utilisation. Le document EP 2 456 043 A1, divulgue un procédé de détermination de consommation de puissance électrique afin de ne pas surpasser la puissance contractée. Le document JP 2008 278700 A divulgue un procédé pour modifier les conditions de fonctionnement d'une source de tension en fonction de mesures d'information représentatives des conditions de fonctionnement. Il est souhaitable de pallier ces différents inconvénients de l'état de la technique.

Il est notamment souhaitable de fournir une solution qui permette de s'affranchir du bruit intrinsèque à de tels compteurs électriques.

Il est aussi souhaitable de fournir une solution qui soit adaptée à la fois aux compteurs électriques monophasés et aux compteurs électriques polyphasés.

Il est aussi souhaitable de fournir une solution qui ne soit pas sensible à une valeur de déphasage entre tension et courant d'alimentation des installations électriques supervisées par de tels compteurs électriques.

Il est aussi souhaitable de fournir une solution qui soit simple à mettre en oeuvre et à faible coût.

L'invention concerne un procédé de gestion d'opérations de comptage d'énergie active et d'opérations de comptage d'énergie réactive, l'énergie active et l'énergie réactive étant consommées par une installation électrique supervisée par un compteur électrique. Le procédé est tel que le compteur électrique effectue les étapes suivantes : effectuer des mesures de puissance active et de puissance réactive consommées par ladite installation électrique ; activer et désactiver sélectivement les opérations de comptage d'énergie active, en fonction au moins d'une comparaison entre la mesure de puissance active et un premier seuil prédéterminé de puissance ; et activer et désactiver sélectivement les opérations de comptage d'énergie réactive, en fonction au moins d'une comparaison entre la mesure de puissance réactive et un second seuil prédéterminé de puissance. Ainsi, en s'appuyant sur des seuils en puissance plutôt que des seuils en courant, les opérations de comptage d'énergie active et les opérations de comptage d'énergie réactive ont une meilleure précision.

Selon un mode de réalisation particulier, le compteur électrique détermine les premier et second seuils de puissance d'après une mesure de tension efficace d'alimentation de l'installation électrique. Ainsi, les premier et second seuils de puissance sont variables et adaptés à la manière dont l'installation électrique est alimentée en tension.

Selon un mode de réalisation particulier, le compteur électrique active ou désactive sélectivement les opérations de comptage d'énergie active, aussi en fonction d'une comparaison entre la mesure de puissance réactive et un troisième seuil prédéterminé de puissance. Ainsi, les opérations de comptage de l'énergie active consommée peuvent être déclenchées par détection de conditions sur la consommation de l'énergie réactive, notamment lorsque le cosinus du déphasage entre courant et tension est proche de zéro.

Selon un mode de réalisation particulier, le compteur électrique détermine le troisième seuil de puissance d'après une mesure de tension efficace d'alimentation de l'installation électrique. Ainsi, le troisième seuil de puissance est variable et adapté à la manière dont l'installation électrique est alimentée en tension.

Selon un mode de réalisation particulier, le compteur électrique active ou désactive sélectivement les opérations de comptage d'énergie réactive, aussi en fonction d'une comparaison entre la mesure de puissance active et un quatrième seuil prédéterminé de puissance. Ainsi, les opérations de comptage de l'énergie réactive consommée peuvent être déclenchées par détection de conditions sur la consommation de l'énergie active, notamment lorsque le sinus du déphasage entre courant et tension est proche de zéro.

Selon un mode de réalisation particulier, le compteur électrique détermine le quatrième seuil de puissance d'après une mesure de tension efficace d'alimentation de l'installation électrique. Ainsi, le quatrième seuil de puissance est variable et adapté à la manière dont l'installation électrique est alimentée en tension.

Selon un mode de réalisation particulier, lorsque le compteur électrique est polyphasé, le compteur électrique effectue les étapes suivantes : effectuer, pour chaque phase à laquelle est connecté le compteur électrique, les mesures de puissance active et de puissance réactive consommées par ladite installation électrique ; effectuer une première comparaison, pour chaque phase à laquelle est connecté le compteur électrique, entre la mesure de puissance active et le premier seuil prédéterminé de puissance ; effectuer une seconde comparaison, pour chaque phase à laquelle est connecté le compteur électrique, entre la mesure de puissance réactive et le second seuil prédéterminé de puissance ; activer et désactiver sélectivement, pour toutes les phases auxquelles est connecté le compteur électrique, les opérations de comptage d'énergie active, en fonction au moins de la première comparaison effectuée pour une dite phase à laquelle est connecté le compteur électrique ; et activer et désactiver sélectivement, pour toutes les phases auxquelles est connecté le compteur électrique, les opérations de comptage d'énergie réactive, en fonction au moins de la seconde comparaison effectuée pour une dite phase à laquelle est connecté le compteur électrique. Ainsi, les opérations de comptage sur une phase à laquelle est connecté le compteur électrique sont interdépendantes avec les opérations de comptage sur chaque autre phase à laquelle est connecté le compteur électrique.

Selon un mode de réalisation particulier, lorsque le compteur électrique est polyphasé, le compteur électrique effectue les étapes suivantes : effectuer, pour chaque phase à laquelle est connecté le compteur électrique, les mesures de puissance active et de puissance réactive consommées par ladite installation électrique ; activer et désactiver sélectivement, pour chaque phase à laquelle est connecté le compteur électrique, les opérations de comptage d'énergie active, en fonction au moins de la comparaison entre la mesure de puissance active et le premier seuil prédéterminé de puissance ; et activer et désactiver sélectivement, pour chaque phase à laquelle est connecté le compteur électrique, les opérations de comptage d'énergie réactive, en fonction au moins de la comparaison entre la mesure de puissance réactive et le second seuil prédéterminé de puissance. Ainsi, les opérations de comptage sont indépendamment gérées pour chacun des phases auxquelles est connecté le compteur électrique.

Selon un mode de réalisation particulier, pour effectuer des mesures de puissance active et de puissance réactive consommées par ladite installation électrique, le compteur électrique effectue les étapes suivantes : obtenir des échantillons de mesure de tension $V_n$ et de mesure de courant $I_n$ ; déterminer la puissance active P de la manière suivante :

$$P = \sum_n V_n . I_n$$

où $n$ est un index d'échantillons de mesure ; appliquer un filtre passe-bas sur les échantillons de mesure de tension $V_n$ et de mesure de courant $I_n$ pour obtenir respectivement des échantillons de tension filtrés $V'_n$ et des échantillons de courant filtrés $I'_n$ ; et déterminer la puissance réactive Q de la manière suivante :

$$Q = \sum_n V'_{n-N/4} . I'_n$$

où N est un nombre d'échantillons, multiple de quatre, par période fondamentale de signal d'alimentation électrique. Ainsi, les mesures de puissance active et de puissance réactive peuvent être facilement obtenues.

L'invention concerne également un compteur électrique adapté pour gérer des opérations de comptage d'énergie active et des opérations de comptage d'énergie réactive, l'énergie active et l'énergie réactive étant consommées par une installation électrique destinée à être supervisée par le compteur électrique, caractérisé en ce que le compteur électrique comporte : des moyens pour effectuer des mesures de puissance active et de puissance réactive consommées par ladite installation électrique ; des moyens pour activer et désactiver sélectivement les opérations de comptage d'énergie active, en fonction au moins d'une comparaison entre la mesure de puissance active et un premier seuil prédéterminé de puissance ; et des moyens pour activer et désactiver sélectivement les opérations de comptage d'énergie réactive, en fonction au moins d'une comparaison entre la mesure de puissance réactive et un second seuil prédéterminé de puissance.

Selon un mode de réalisation particulier, les moyens pour effectuer les mesures de puissance active et de puissance réactive utilisent des moyens pour effectuer des mesures de courant grâce à un montage comportant successivement un capteur de Rogowski, un filtre passe-bas de second ordre et un intégrateur destiné à compenser une fonction de dérivation du capteur de Rogowski. Ainsi, les mesures de puissance active et de puissance réactive sont précises et faciles à mettre en oeuvre.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1A illustre schématiquement un premier système électrique dans lequel l'invention peut être mise en oeuvre ;
- la Fig. 1B illustre schématiquement un second système électrique dans lequel l'invention peut être mise en oeuvre ;

- la Fig. 2 illustre schématiquement un exemple d'architecture matérielle partielle d'un compteur électrique au sein du premier ou du second système électrique ;
- la Fig. 3 illustre schématiquement un premier algorithme de gestion d'activation et de désactivation d'opérations de comptage effectuées par un compteur électrique ;
- la Fig. 4 représente un schéma de principe d'une chaîne de mesure ;
- la Fig. 5 illustre schématiquement un second algorithme de gestion d'activation et de désactivation d'opérations de comptage effectuées par le compteur électrique ; et
- la Fig. 6 illustre schématiquement un troisième algorithme de gestion d'activation et de désactivation d'opérations de comptage effectuées par le compteur électrique.

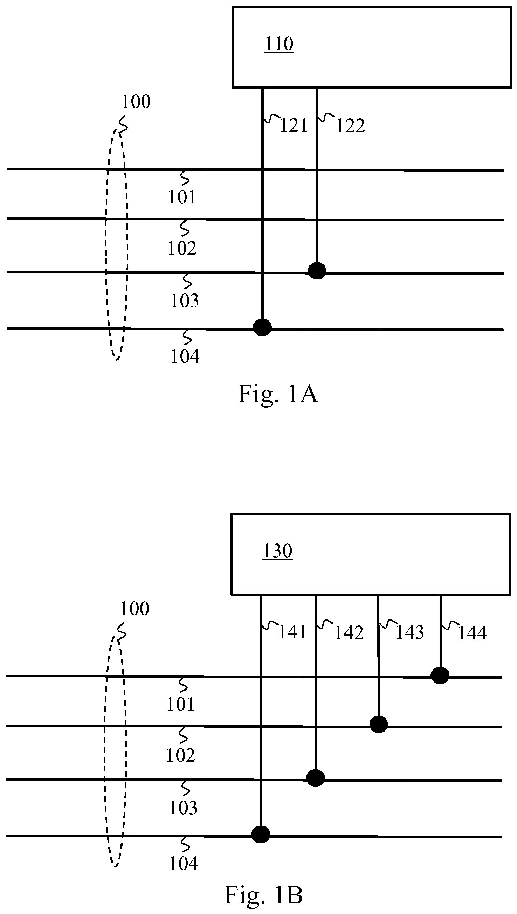

La Fig. 1A illustre schématiquement un premier système électrique dans lequel l'invention peut être mise en oeuvre.

Le premier système électrique de la Fig. 1A comporte un réseau d'alimentation électrique 100 constitué d'une pluralité de fils, un fil étant dédié au neutre et au moins un fil étant dédié à au moins une phase. Dans l'exemple de réalisation représenté par la Fig. 1A, le réseau d'alimentation électrique 100 est un système à trois phases, et est donc constitué de quatre fils: un fil de neutre 104, un fil de première phase 101, un fil de seconde phase 102 et un fil de troisième phase 103. Le premier système électrique de la Fig. 1A pourrait toutefois reposer sur un réseau d'alimentation électrique monophasé.

Le premier système électrique de la Fig. 1A comporte en outre un compteur électrique 110, c'est-à-dire un dispositif servant à effectuer des opérations de comptage de quantité d'énergie électrique consommée par une installation électrique que le compteur électrique 110 est en charge de superviser. Le compteur électrique 110 est connecté à un des fils de phase du réseau d'alimentation électrique 100, ainsi qu'au fil de neutre 104, par des liens respectifs 122 et 121. On est, dans ce cas, en présence d'un compteur électrique monophasé.

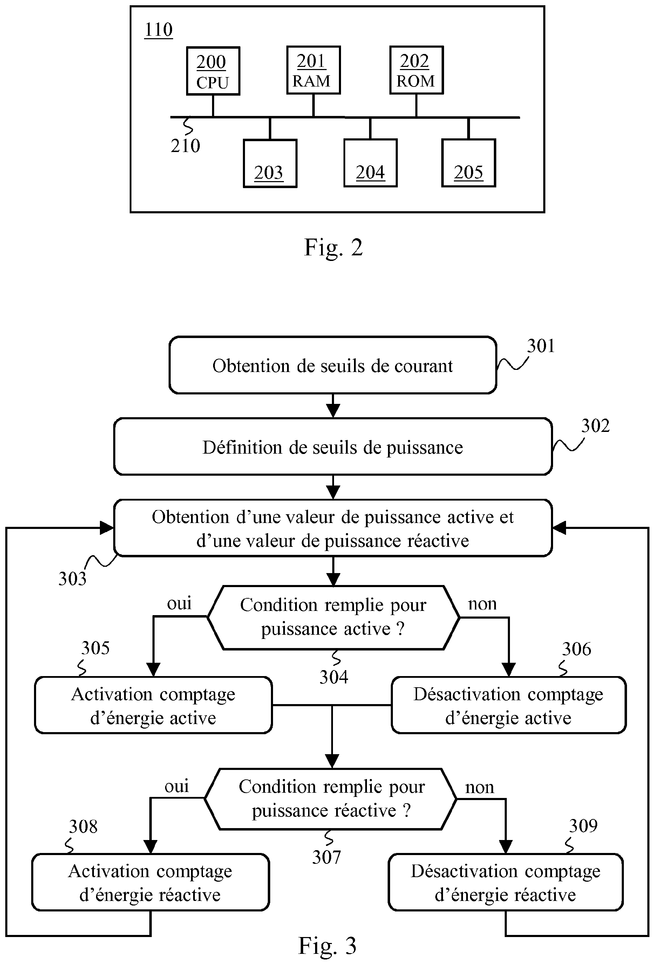

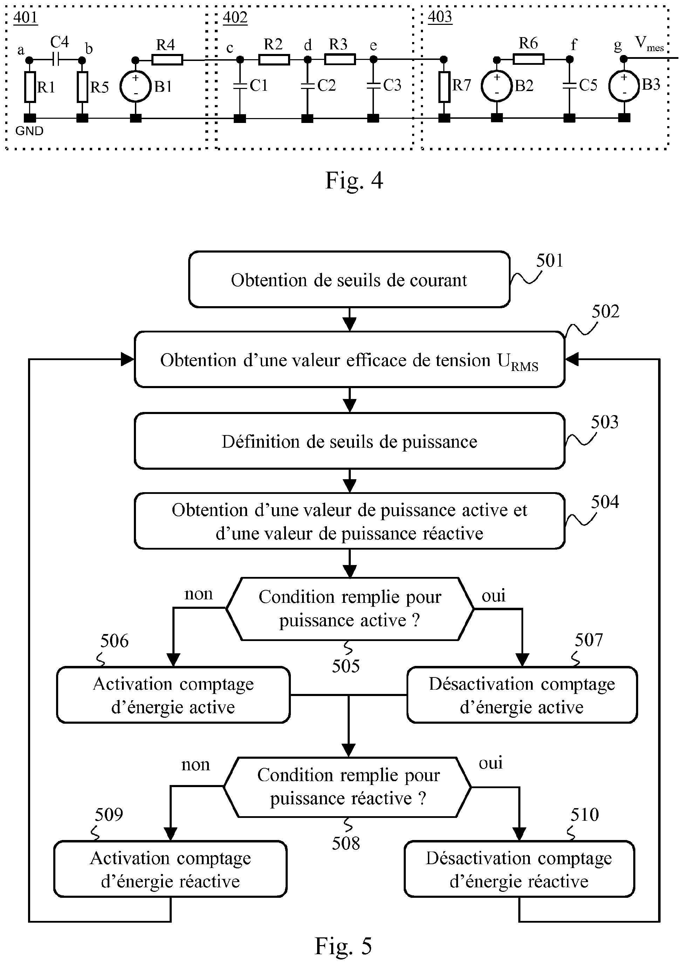

Les opérations de comptage effectuées par le compteur électrique 110 sont relatives à l'énergie active consommée par l'installation électrique et à l'énergie réactive consommée par l'installation électrique. Des situations d'activation et de désactivation des opérations de comptage applicables au cas de compteurs électriques monophasés sont détaillées par la suite en relation avec les Figs. 3 et 5.

La Fig. 1B illustre schématiquement un second système électrique dans lequel l'invention peut être mise en oeuvre.

Le second système électrique de la Fig. 1B comporte un réseau d'alimentation électrique 100 constitué d'une pluralité de fils, un fil étant dédié au neutre et une pluralité de fils étant dédiée à une pluralité de phases respectives. Dans l'exemple de réalisation représenté par la Fig. 1B, le réseau d'alimentation électrique 100 est un système à trois phases, et est donc constitué de quatre fils : le fil de neutre 104, le fil de première phase 101, le fil de seconde phase 102 et le fil de troisième phase 103. Le second système électrique de la Fig. 1B pourrait toutefois reposer sur un réseau d'alimentation électrique polyphasé comportant un nombre différent de phases.

Le second système électrique de la Fig. 1B comporte en outre un compteur électrique 130. Le compteur électrique 130 est connecté à une pluralité de fils de phase du réseau d'alimentation électrique 100, ainsi qu'au fil de neutre 104. Dans le second système électrique représenté à la Fig. 1B, le compteur électrique 130 est connecté aux fils 101, 102, 103, 104 par des liens respectifs 144, 143, 142, 141. On est, dans ce cas, en présence d'un compteur électrique polyphasé, et plus particulièrement en présence d'un compteur électrique triphasé pour ce qui est de la représentation de la Fig. 1B.

Les opérations de comptage effectuées par le compteur électrique 130 sont relatives à l'énergie active consommée par phase par l'installation électrique et à l'énergie réactive consommée par phase par l'installation électrique. Dans une variante de réalisation, les opérations de comptage effectuées par le compteur électrique 130 sont relatives à l'énergie active consommée par l'installation électrique sur l'ensemble des phases auxquelles est connecté le compteur électrique 130 et à l'énergie réactive consommée par l'installation électrique sur l'ensemble des phases auxquelles est connecté le compteur électrique 130.

Des situations d'activation et de désactivation des opérations de comptage applicables au cas de compteurs électriques polyphasés sont détaillées par la suite en relation avec les Figs. 3, 5 et 6.

La Fig. 2 illustre schématiquement un exemple d'architecture du compteur électrique 110 et/ou du compteur électrique 130. Considérons par la suite, à titre illustratif, que la Fig. 2 représente schématiquement un exemple d'architecture du compteur électrique 110. Le compteur électrique 110 comporte alors, reliés par un bus de communication 210 : un processeur ou CPU (« Central Processing Unit » en anglais) 200 ; une mémoire vive RAM (« Random Access Memory » en anglais) 201 ; une mémoire morte ROM (« Read Only Memory » en anglais) 202 ; une unité de stockage ou un lecteur de support de stockage, tel qu'un lecteur de cartes SD (« Secure Digital » en anglais) 203 ; une interface homme-machine 204 permettant au compteur électrique 110 d'interagir avec un utilisateur pour fournir des indications de comptage d'énergie active et d'énergie réactive consommées par l'installation électrique supervisée par ledit compteur électrique 110; et une interface 205 permettant au compteur électrique 110 de réaliser les opérations de comptage d'énergie consommée par l'installation électrique supervisée par le compteur électrique 110.

Le compteur électrique 110 peut en outre comporter une interface de communication par courants porteurs en ligne PLT (« PowerLine Transmission » en anglais) permettant audit compteur électrique 110 de fournir, à un concentrateur de données DC (« Data Concentrator » en anglais) dans un cadre de gestion avancée de comptage AMM (« Advanced Metering Management » en anglais), des indications de comptage d'énergie active et d'énergie réactive consommées par l'installation électrique supervisée par ledit compteur électrique 110.

Le processeur 200 est capable d'exécuter des instructions chargées dans la RAM 201 à partir de la ROM 202, d'une mémoire externe (non représentée), d'un support de stockage, tel qu'une carte SD, ou d'un réseau de communication. Lorsque le compteur électrique 110 est mis sous tension, le processeur 200 est capable de lire de la RAM 201 des instructions et de les exécuter. Ces instructions forment un programme d'ordinateur causant la mise en oeuvre, par le processeur 200, de tout ou partie des algorithmes décrits ci-après en relation avec les Figs. 3, 5 et 6.

Tout ou partie des algorithmes décrits ci-après en relation avec les Figs. 3, 5 et 6 peut être implémenté sous forme logicielle par exécution d'un ensemble d'instructions par une machine programmable, telle qu'un DSP (« Digital Signal Processor » en anglais) ou un microcontrôleur, ou être implémenté sous forme matérielle par une machine ou un composant dédié, tel qu'un FPGA (« Field-Programmable Gate Array » en anglais) ou un ASIC (« Application-Specific Integrated Circuit » en anglais).

La Fig. 3 illustre schématiquement un premier algorithme de gestion d'activation et de désactivation d'opérations de comptage effectuées par un compteur électrique. L'algorithme de la Fig. 3 peut être mis en oeuvre par un compteur électrique monophasé pour la phase à laquelle ledit compteur électrique est connecté. L'algorithme de la Fig. 3 peut aussi être mis en oeuvre par un compteur électrique polyphasé pour chaque phase à laquelle ledit compteur électrique est connecté. Considérons par la suite que l'algorithme de la Fig. 3 est effectué par le compteur électrique 110.

Dans une étape 301, le compteur électrique 110 obtient des valeurs de seuils de courant prédéfinis pour la phase considérée.

Dans un premier mode de réalisation, le compteur électrique 110 obtient un premier seuil de courant I_P_Th et un second seuil de courant I_Q_Th. Par exemple, le premier seuil de courant I_P_Th est fixé à 3 mA et le second seuil de courant I_Q_Th est fixé à 8 mA.

Dans un second mode de réalisation, le compteur électrique 110 obtient un premier seuil de courant I_P_Th1, un second seuil de courant I_P_Th2, un troisième seuil de courant I_Q_Th1 et un quatrième seuil de courant I_Q_Th2. Par exemple, le premier seuil de courant I_P_Th1 est fixé à 3 mA, le second seuil de courant I_P_Th2 est fixé à 8 mA, le troisième seuil de courant I_Q_Th1 est fixé à 8 mA et le quatrième seuil de courant I_Q_Th2 est fixé à 3 mA.

Dans une étape 302 suivante, le compteur électrique 110 définit, pour la phase considérée, des seuils de puissance en fonction des seuils de courant obtenus à l'étape 301.

Dans le premier mode de réalisation, le compteur électrique 110 définit un premier seuil de puissance P_Th et un second seuil de puissance Q_Th. Le premier seuil de puissance P_Th est relatif à la puissance active consommée par l'installation électrique supervisée par le compteur électrique 110 et est défini comme suit :

$$ P\_Th = I\_P\_Th * U_{RMS} $$

et, le second seuil de puissance Q_Th est relatif à la puissance réactive consommée par l'installation électrique supervisée par le compteur électrique 110 et est défini comme suit :

$$ Q\_Th = I\_Q\_Th * U_{RMS} $$

où $U_{RMS}$ fait référence à une valeur de tension efficace sur la phase sur laquelle le compteur électrique 110 est connecté.

Dans le second mode de réalisation, le compteur électrique 110 définit un premier seuil de puissance P_Th1, un second seuil de puissance P_Th2, un troisième seuil de puissance Q_Th1 et un quatrième seuil de puissance Q_Th2. Le premier seuil de puissance P_Th1 et le second seuil de puissance P_Th2 sont relatifs à la puissance active consommée par l'installation électrique supervisée par le compteur électrique 110 via la phase considérée et sont définis comme suit :

$$ P\_Th1 = I\_P\_Th1 * U_{RMS} $$

$$ P\_Th2 = I\_P\_Th2 * U_{RMS} $$

et, le troisième seuil de puissance Q_Th1 et le quatrième seuil de puissance Q_Th2 sont relatifs à la puissance réactive consommée par l'installation électrique supervisée par le compteur électrique 110 via la phase considérée et sont définis comme suit :

$$ Q\_Th1 = I\_Q\_Th1 * U_{RMS} $$

$$ Q\_Th2 = I\_Q\_Th2 * U_{RMS} $$

Dans le cadre de l'algorithme de la Fig. 3, la valeur $U_{RMS}$ est prédéfinie. Le compteur électrique 110 obtient la valeur de tension efficace $U_{RMS}$ en accédant à un registre ou une zone mémoire, où ladite valeur a été stockée en usine ou lors d'une phase de configuration préalable du compteur électrique 110.

Dans une étape 303 suivante, le compteur électrique 110 effectue des mesures de puissance active P et de puissance réactive Q consommées par l'installation électrique supervisée par le compteur électrique 110 via la phase considérée. Ces mesures sont à distinguer des opérations de comptage elles-mêmes.

La puissance active P est obtenue de la manière suivante :

$$P = \sum_n V_n . I_n$$

où $n$ est un index d'échantillons de mesure de tension $V_n$ et de mesure de courant $I_n$, la puissance active P étant ainsi obtenue par échantillonnage de tension et de courant sur une période T prédéfinie. Par exemple, la période T est égale à 200 ms.

La puissance réactive Q est obtenue tout d'abord en filtrant par un même filtre passe-bas les échantillons de tension et de courant de manière à éliminer les harmoniques et à ne conserver que la fréquence fondamentale (on note respectivement $V'_n$ et $I'_n$ les échantillons de tension et de courant filtrés), puis en créant un décalage relatif d'un quart de la période fondamentale $T_0$ du signal d'alimentation électrique (la valeur de $T_0$ étant typiquement égale à 20$ms$ pour une fréquence fondamentale secteur de 50$Hz$) entre les échantillons de courant filtrés et les échantillons de tension filtrés de sorte qu'un échantillon $n$ de courant filtré soit associé avec un échantillon $n - N/4$ de tension filtré ($N$ est un nombre d'échantillons, multiple de quatre, par période $T_0$), étant donné que le signal d'alimentation électrique est un signal périodique stable. En d'autres termes, la puissance réactive Q est obtenue de la manière suivante :

$$Q = \sum_n V'_{n-N/4} . I'_n$$

L'obtention des échantillons de mesure de tension $V_n$ peut se faire par application d'un pont diviseur de tension entre la phase considérée et le neutre. L'utilisation d'un pont diviseur de tension permet de ramener la tension à une valeur directement exploitable par un processeur via un convertisseur analogique numérique.

L'obtention des échantillons de mesure de courant $I_n$ peut se faire grâce à un montage à base de capteur de Rogowski. Un schéma de principe d'un tel montage est illustré à la Fig. 4.

Sur la Fig. 4, un capteur de Rogowski 401 est schématiquement représenté. Un capteur de Rogowski est constitué d'une bobine entourant un conducteur, ici le fil de la phase considérée. La tension induite dans la bobine est proportionnelle au taux de changement (dérivée) du courant dans le conducteur, le capteur de Rogowski induisant alors une fonction de dérivation.

Sur la Fig. 4, le capteur de Rogowski 401 est suivi d'un filtre passe-bas de second ordre 402, de manière à supprimer les bruits hautes fréquences du signal mesuré, tout en y conservant les harmoniques qui doivent être pris en compte dans la mesure de puissance active.

Sur la Fig. 4, le filtre passe-bas de second ordre 402 est suivi d'un circuit intégrateur 403, dont le rôle est de compenser la fonction de dérivation induite par le capteur de Rogowski 401. En sortie du circuit intégrateur 403, une tension $V_{mes}$ est mesurée. Cette tension $V_{mes}$ est une image du courant passant dans le conducteur autour duquel est installée la bobine du capteur de Rogowski.

Sur la Fig. 4, le principe du capteur de Rogowski 401 est schématisé par un premier montage et un second montage successifs. Le premier montage comporte une résistance R1 (par exemple de 7.3 m$\Omega$) entre la masse (notée GND) et un point « a », un condensateur C4 (par exemple de 10 pF) entre le point « a » et un point « b » et une résistance R5 (par exemple de 100 $\Omega$) entre la masse et le point « b ». Le second montage comporte une source de tension continue B1 à la masse, en série avec une résistance R4 (par exemple de 160 $\Omega$) pour parvenir à un point « c ».

Sur la Fig. 4, le principe du filtre passe-bas 402 est schématisé par un troisième montage. Ce troisième montage comporte un condensateur C1 (par exemple de 33 nF) entre le point « c » et la masse, une résistance R2 (par exemple de 100 $\Omega$) entre le point « c » et un point « d », un condensateur C2 (par exemple de 33 nF) entre le point « d » et la masse, une résistance R3 (par exemple de 1 k$\Omega$) entre le point « d » et un point « e », et un condensateur C3 (par exemple de 33 nF) entre le point « e » et la masse.

Sur la Fig. 4, le principe du circuit intégrateur 403 schématisé par un quatrième montage, un cinquième montage et un sixième montage successifs. Le quatrième montage comporte une résistance R7 (par exemple de 400 k$\Omega$) entre le point « e » et la masse. Le cinquième montage comporte une source de tension continue B2 à la masse, en série avec une résistance R6 (par exemple de 100 k$\Omega$) pour parvenir à un point « f ». Le cinquième montage comporte en outre un condensateur C5 (par exemple de 1 mF) entre le point « f » et la masse. Le sixième montage comporte une source de tension continue B3 entre la masse et un point « g ». La tension $V_{mes}$, image du courant passant dans le conducteur autour duquel est placée la bobine du capteur de Rogowski 401, est alors mesurée au point « g ».

De retour à la Fig. 3, dans une étape 304 suivante, le compteur électrique 110 vérifie au moins si une première condition est remplie pour déclencher ou maintenir les opérations de comptage d'énergie active consommée par l'installation électrique via la phase considérée.

Plus précisément, dans le premier mode de réalisation, le compteur électrique 110 vérifie par comparaison si la puissance active mesurée P pour la phase considérée est supérieure au premier seuil de puissance P_Th. Si tel est le cas, une étape 305 est effectuée ; sinon, une étape 306 est effectuée.

Plus précisément, dans le second mode de réalisation, le compteur électrique 110 vérifie par comparaison si au moins l'une des premières conditions suivantes est vérifiée :

- condition A : la puissance active mesurée P est supérieure au premier seuil de puissance P_Th1 pour la phase considérée ; et
- condition B : la puissance réactive mesurée Q est supérieure au quatrième seuil de puissance Q_Th2 pour la phase considérée.

Si tel est le cas, l'étape 305 est effectuée ; sinon, l'étape 306 est effectuée.

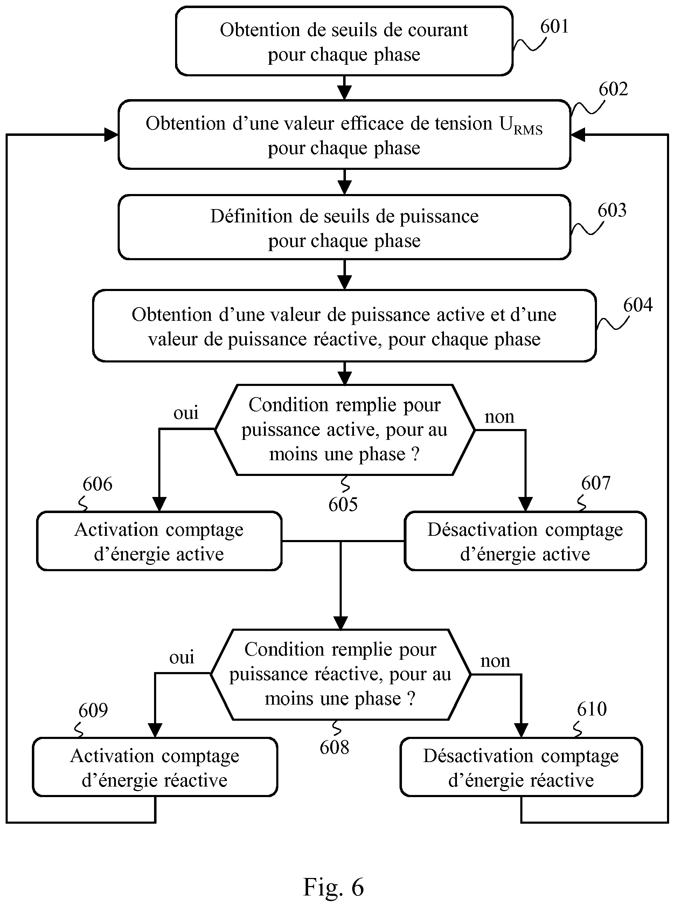

Dans l'étape 305, le compteur électrique 110 active les opérations de comptage d'énergie active consommée par l'installation électrique supervisée par le compteur électrique 110. Les opérations de comptage d'énergie active sont déclenchées pour la phase à laquelle est connecté le compteur électrique, en cas de compteur électrique monophasé. Les opérations de comptage d'énergie active sont déclenchées pour la phase considérée, en cas de compteur électrique polyphasé. La Fig. 6, détaillée ci-après, montre un mode de réalisation dans lequel le déclenchement des opérations de comptage d'énergie active est géré simultanément pour toutes les phases sur lesquelles est connecté un compteur électrique polyphasé. Si les opérations de comptage d'énergie active étaient déjà en cours, le compteur électrique 110 poursuit les opérations de comptage d'énergie active. Puis, une étape 307 est effectuée.

Dans l'étape 306, le compteur électrique 110 désactive les opérations de comptage d'énergie active consommée par l'installation électrique supervisée par le compteur électrique 110. Les opérations de comptage d'énergie active sont désactivées pour la phase à laquelle est connecté le compteur électrique, en cas de compteur électrique monophasé. Les opérations de comptage d'énergie active sont désactivées pour la phase considérée, en cas de compteur électrique polyphasé. La Fig. 6, détaillée ci-après, montre un mode de réalisation dans lequel la désactivation des opérations de comptage d'énergie active est gérée simultanément pour toutes les phases sur lesquelles est connecté un compteur électrique polyphasé. Si les opérations de comptage d'énergie active étaient déjà désactivées, le compteur électrique 110 maintient désactivées les opérations de comptage d'énergie active. Puis, l'étape 307 est effectuée.

Dans l'étape 307, le compteur électrique 110 vérifie si au moins une seconde condition est remplie pour déclencher ou maintenir les opérations de comptage d'énergie réactive consommée par l'installation électrique via la phase considérée.

Plus précisément, dans le premier mode de réalisation, le compteur électrique 110 vérifie par comparaison si la puissance réactive mesurée Q est supérieure au second seuil de puissance Q_Th. Si tel est le cas, une étape 308 est effectuée ; sinon, une étape 309 est effectuée.

Plus précisément, dans le second mode de réalisation, le compteur électrique 110 vérifie par comparaison si au moins l'une des secondes conditions suivantes est vérifiée :

- condition C : la puissance active mesurée P est supérieure au second seuil de puissance P_Th2 pour la phase considérée ; et
- condition D : la puissance réactive mesurée Q est supérieure au troisième seuil de puissance Q_Th1 pour la phase considérée.

Si tel est le cas, l'étape 308 est effectuée ; sinon, l'étape 309 est effectuée.

Dans l'étape 308, le compteur électrique 110 active les opérations de comptage d'énergie réactive consommée par l'installation électrique supervisée par le compteur électrique 110. Les opérations de comptage d'énergie réactive sont déclenchées pour la phase à laquelle est connecté le compteur électrique, en cas de compteur électrique monophasé. Les opérations de comptage d'énergie réactive sont déclenchées pour la phase considérée, en cas de compteur électrique polyphasé. La Fig. 6, détaillée ci-après, montre un mode de réalisation dans lequel le déclenchement des opérations de comptage d'énergie réactive est géré simultanément pour toutes les phases sur lesquelles est connecté un compteur électrique polyphasé. Si les opérations de comptage d'énergie réactive étaient déjà en cours, le compteur électrique 110 poursuit les opérations de comptage d'énergie réactive. Puis, l'étape 303 est réitérée.

Dans l'étape 309, le compteur électrique 110 désactive les opérations de comptage d'énergie réactive consommée par l'installation électrique supervisée par le compteur électrique 110. Les opérations de comptage d'énergie réactive sont désactivées pour la phase à laquelle est connecté le compteur électrique, en cas de compteur électrique monophasé. Les opérations de comptage d'énergie réactive sont désactivées pour la phase considérée, en cas de compteur électrique polyphasé. La Fig. 6, détaillée ci-après, montre un mode de réalisation dans lequel la désactivation des opérations de comptage d'énergie réactive est gérée simultanément pour toutes les phases sur lesquelles est connecté un compteur électrique polyphasé. Si les opérations de comptage d'énergie réactive étaient déjà désactivées, le compteur électrique 110 maintient désactivées les opérations de comptage d'énergie réactive. Puis, l'étape 303 est réitérée.

Il ressort de ce qui précède que le compteur électrique 110 active et désactive sélectivement les opérations de comptage d'énergie active, en fonction au moins d'une comparaison entre la mesure de puissance active et un seuil prédéterminé de puissance. S'appuyer sur un seuil de puissance plutôt qu'un seuil de courant permet de s'affranchir du bruit intrinsèque au compteur électrique 110. En effet, déterminer une puissance active consommée revient à déterminer une espérance mathématique, ce qui fait que l'effet du bruit intrinsèque du compteur électrique dans les mesures de courant et l'effet du bruit intrinsèque du compteur électrique dans les mesures de tension sont décorrélés et s'annulent.

En outre, le compteur électrique 110 peut activer et désactiver sélectivement les opérations de comptage d'énergie active, en fonction aussi d'une comparaison entre la mesure de puissance réactive et un autre seuil prédéterminé de puissance. Prendre en compte l'évolution de la puissance réactive pour l'activation et la désactivation des opérations de comptage d'énergie active permet de s'affranchir du déphasage entre courant et tension, notamment lorsque le cosinus du déphasage entre courant et tension est proche de zéro.

Il ressort aussi de ce qui précède que le compteur électrique 110 active et désactive sélectivement les opérations de comptage d'énergie réactive, en fonction au moins d'une comparaison entre la mesure de puissance réactive et un seuil prédéterminé de puissance. S'appuyer sur un seuil de puissance plutôt qu'un seuil de courant permet de s'affranchir du bruit intrinsèque au compteur électrique 110. En effet, déterminer une puissance réactive consommée revient à déterminer une espérance mathématique, ce qui fait que l'effet du bruit intrinsèque du compteur électrique dans les mesures de courant et l'effet du bruit intrinsèque du compteur électrique dans les mesures de tension sont décorrélés et s'annulent.

En outre, le compteur électrique 110 peut activer et désactiver sélectivement les opérations de comptage d'énergie réactive, en fonction en outre d'une comparaison entre la mesure de puissance active et un autre seuil prédéterminé de puissance. Prendre en compte l'évolution de la puissance active pour l'activation et la désactivation des opérations de comptage d'énergie réactive permet de s'affranchir du déphasage entre courant et tension, notamment lorsque le sinus du déphasage entre courant et tension est proche de zéro.

Il ressort aussi de ce qui précède que, lorsque l'algorithme de la Fig. 3 est effectué par le compteur électrique polyphasé 130, une instance de l'algorithme de la Fig. 3 est mise en oeuvre indépendamment sur chacune des phases. Les opérations de comptage d'énergie active et réactive s'effectuent alors indépendamment sur chacune des phases auxquelles est connecté le compteur électrique polyphasé 130. Il est cependant possible de rendre ces opérations de comptage interdépendantes, tel que décrit ci-après en relation avec la Fig. 6.

Il convient de noter qu'il est possible de mettre en oeuvre le premier mode de réalisation pour activer et désactiver sélectivement les opérations de comptage d'énergie active, et de mettre en oeuvre le second mode de réalisation pour activer et désactiver sélectivement les opérations de comptage d'énergie réactive. Il convient aussi de noter qu'il est possible de mettre en oeuvre le second mode de réalisation pour activer et désactiver sélectivement les opérations de comptage d'énergie active, et de mettre en oeuvre le premier mode de réalisation pour activer et désactiver sélectivement les opérations de comptage d'énergie réactive.

La Fig. 5 illustre schématiquement un second algorithme de gestion d'activation et de désactivation d'opérations de comptage effectuées par un compteur électrique. L'algorithme de la Fig. 5 est une alternative à l'algorithme de la Fig. 3, dans lequel chaque seuil de puissance est dynamiquement déterminé. Considérons par la suite que l'algorithme de la Fig. 5 est effectué par le compteur électrique 110.

Dans une étape 501, le compteur électrique 110 obtient des valeurs de seuils de courant prédéfinis pour la phase considérée.

Dans le premier mode de réalisation, le compteur électrique 110 obtient le premier seuil de courant I_P_Th et le second seuil de courant I_Q_Th, déjà mentionnés en relation avec la Fig. 3.

Dans le second mode de réalisation, le compteur électrique 110 obtient le premier seuil de courant I_P_Th1, le second seuil de courant I_P_Th2, le troisième seuil de courant I_Q_Th1 et le quatrième seuil de courant I_Q_Th2, déjà mentionnés en relation avec la Fig. 3.

Dans une étape 502 suivante, le compteur électrique 110 obtient par mesure une valeur de tension efficace $U_{RMS}$ sur la phase sur laquelle le compteur électrique 110 est connecté. Dans le cas du compteur électrique polyphasé 130, une valeur de tension efficace $U_{RMS}$ est obtenue pour chaque phase sur laquelle est connecté le compteur électrique 130.

Dans une étape 503 suivante, le compteur électrique 110 définit, pour la phase considérée, des seuils de puissance en fonction des seuils de courant obtenus à l'étape 501 et en fonction de la valeur de tension efficace $U_{RMS}$ obtenue à l'étape 502.

Dans le premier mode de réalisation, le compteur électrique 110 définit le premier seuil de puissance P_Th et le second seuil de puissance Q_Th, déjà mentionnés en relation avec la Fig. 3.

Dans le second mode de réalisation, le compteur électrique 110 définit le premier seuil de puissance P_Th1, le second seuil de puissance P_Th2, le troisième seuil de puissance Q_Th1 et le quatrième seuil de puissance Q_Th2, déjà mentionnés en relation avec la Fig. 3.

La différence avec l'algorithme de la Fig. 3 réside en ce que la valeur de tension efficace $U_{RMS}$ est ici mesurée plutôt que d'être fixe, ce qui implique des valeurs variables des seuils de puissance définis à l'étape 503.

Dans une étape 504 suivante, le compteur électrique 110 effectue des mesures de puissance active P et de puissance réactive Q consommées par l'installation électrique supervisée par le compteur électrique 110, tel que déjà décrit en relation avec la Fig. 3.

Dans une étape 505 suivante, le compteur électrique 110 vérifie au moins si la première condition est remplie pour déclencher ou maintenir les opérations de comptage d'énergie active.

Plus précisément, dans le premier mode de réalisation, le compteur électrique 110 vérifie par comparaison si la puissance active mesurée P est supérieure pour la phase considérée au premier seuil de puissance P_Th. Si tel est le cas, une étape 506 est effectuée ; sinon, une étape 507 est effectuée.

Plus précisément, dans le second mode de réalisation, le compteur électrique 110 vérifie par comparaison si au moins l'une des premières conditions suivantes est vérifiée :

- condition A : la puissance active mesurée P est supérieure au premier seuil de puissance P_Th1 pour la phase considérée ; et
- condition B : la puissance réactive mesurée Q est supérieure au quatrième seuil de puissance Q_Th2 pour la phase considérée.

Si tel est le cas, l'étape 506 est effectuée ; sinon, l'étape 507 est effectuée.

Dans l'étape 506, le compteur électrique 110 active les opérations de comptage d'énergie active consommée par l'installation électrique supervisée par le compteur électrique 110. Les opérations de comptage d'énergie active sont déclenchées pour la phase à laquelle est connecté le compteur électrique, en cas de compteur électrique monophasé. Les opérations de comptage d'énergie active sont déclenchées pour la phase considérée, en cas de compteur électrique polyphasé. La Fig. 6, détaillée ci-après, montre un mode de réalisation dans lequel le déclenchement des opérations de comptage d'énergie active est géré simultanément pour toutes les phases sur lesquelles est connecté un compteur électrique polyphasé. Si les opérations de comptage d'énergie active étaient déjà en cours, le compteur électrique 110 poursuit les opérations de comptage d'énergie active consommée par l'installation électrique supervisée par le compteur électrique 110. Puis, une étape 508 est effectuée.

Dans l'étape 507, le compteur électrique 110 désactive les opérations de comptage d'énergie active consommée par l'installation électrique supervisée par le compteur électrique 110. Les opérations de comptage d'énergie active sont désactivées pour la phase à laquelle est connecté le compteur électrique, en cas de compteur électrique monophasé. Les opérations de comptage d'énergie active sont désactivées pour la phase considérée, en cas de compteur électrique polyphasé. La Fig. 6, détaillée ci-après, montre un mode de réalisation dans lequel la désactivation des opérations de comptage d'énergie active est gérée simultanément pour toutes les phases sur lesquelles est connecté un compteur électrique polyphasé. Si les opérations de comptage d'énergie active étaient déjà désactivées, le compteur électrique 110 maintient désactivées les opérations de comptage d'énergie active. Puis, l'étape 508 est effectuée.

Dans l'étape 508, le compteur électrique 110 vérifie si au moins une seconde condition est remplie pour déclencher ou maintenir le comptage d'énergie réactive.

Plus précisément, dans le premier mode de réalisation, le compteur électrique 110 vérifie par comparaison si la puissance réactive mesurée Q est supérieure pour la phase considérée au second seuil de puissance Q_Th. Si tel est le cas, une étape 509 est effectuée ; sinon, une étape 510 est effectuée.

Plus précisément, dans le second mode de réalisation, le compteur électrique 110 vérifie par comparaison si au moins l'une des secondes conditions suivantes est vérifiée :

- condition C : la puissance active mesurée P est supérieure au second seuil de puissance P_Th2 pour la phase considérée ; et
- condition D : la puissance réactive mesurée Q est supérieure au troisième seuil de puissance Q_Th1 pour la phase considérée.

Si tel est le cas, l'étape 509 est effectuée ; sinon, l'étape 510 est effectuée.

Dans l'étape 509, le compteur électrique 110 active les opérations de comptage d'énergie réactive consommée par l'installation électrique supervisée par le compteur électrique 110. Les opérations de comptage d'énergie réactive sont déclenchées pour la phase à laquelle est connecté le compteur électrique, en cas de compteur électrique monophasé. Les opérations de comptage d'énergie réactive sont déclenchées pour la phase considérée, en cas de compteur électrique polyphasé. La Fig. 6, détaillée ci-après, montre un mode de réalisation dans lequel le déclenchement des opérations de comptage d'énergie réactive est géré simultanément pour toutes les phases sur lesquelles est connecté un compteur électrique polyphasé. Si les opérations de comptage d'énergie réactive étaient déjà en cours, le compteur électrique 110 poursuit les opérations de comptage d'énergie réactive consommée par l'installation électrique supervisée par le compteur électrique 110. Puis, l'étape 502 est réitérée. Une nouvelle définition des seuils de puissance se met alors en place, après une nouvelle mesure de la tension efficace $U_{RMS}$ pour la phase considérée.

Dans l'étape 510, le compteur électrique 110 désactive les opérations de comptage d'énergie réactive consommée par l'installation électrique supervisée par le compteur électrique 110. Les opérations de comptage d'énergie réactive sont désactivées pour la phase à laquelle est connecté le compteur électrique, en cas de compteur électrique monophasé. Les opérations de comptage d'énergie réactive sont désactivées pour la phase considérée, en cas de compteur électrique polyphasé. La Fig. 6, détaillée ci-après, montre un mode de réalisation dans lequel la désactivation des opérations de comptage d'énergie réactive est gérée simultanément pour toutes les phases sur lesquelles est connecté un compteur électrique polyphasé. Si les opérations de comptage d'énergie réactive étaient déjà désactivées, le compteur électrique 110 maintient désactivées les opérations de comptage d'énergie réactive. Puis, l'étape 502 est réitérée. Une nouvelle définition des seuils de puissance se met alors en place, après une nouvelle mesure de la tension efficace $U_{RMS}$.

Lorsque l'algorithme de la Fig. 5 est effectué par le compteur électrique polyphasé 130, une instance de l'algorithme de la Fig. 5 est ainsi mise en oeuvre indépendamment sur chacune des phases. Les opérations de comptage d'énergie active et réactive s'effectuent alors indépendamment sur chacune des phases auxquelles est connecté le compteur électrique polyphasé 130. Il est cependant possible de rendre ces opérations de comptage interdépendantes, tel que décrit ci-après en relation avec la Fig. 6.

Comme dans le cadre de l'algorithme de la Fig. 3, l'algorithme de la Fig. 5 fait que le compteur électrique 110 active et désactive sélectivement les opérations de comptage d'énergie active, en fonction au moins d'une comparaison entre la mesure de puissance active et un seuil prédéterminé de puissance, et que le compteur électrique 110 active et désactive sélectivement les opérations de comptage d'énergie réactive, en fonction au moins d'une comparaison entre la mesure de puissance réactive et un autre seuil prédéterminé de puissance.

La Fig. 6 illustre schématiquement un troisième algorithme de gestion d'activation et de désactivation d'opérations de comptage effectuées par un compteur électrique. L'algorithme de la Fig. 6 est plus particulièrement adapté aux opérations de comptage effectuées par un compteur électrique polyphasé. Considérons par la suite que l'algorithme de la Fig. 6 est effectué par le compteur électrique 130.

Dans une étape 601, le compteur électrique 130 obtient, pour chaque phase à laquelle est connecté le compteur électrique 130, des valeurs de seuils de courant prédéfinis, comme déjà décrit en relation avec la Fig. 3.

Dans le premier mode de réalisation, le compteur électrique 130 obtient, pour chaque phase à laquelle le compteur électrique 130 est connecté, le premier seuil de courant I_P_Th et le second seuil de courant I_Q_Th. Une valeur de premier seuil de courant I_P_Th peut être définie pour chaque phase à laquelle est connecté le compteur électrique 130. Une valeur de second seuil de courant I_Q_Th peut être définie pour chaque phase à laquelle est connecté le compteur électrique 130.

Dans le second mode de réalisation, le compteur électrique 130 obtient le premier seuil de courant I_P_Th1, le second seuil de courant I_P_Th2, le troisième seuil de courant I_Q_Th1 et le quatrième seuil de courant I_Q_Th2, et ce pour chaque phase à laquelle est connecté le compteur électrique 130. Une valeur de premier seuil de courant I_P_Th1 peut être définie pour chaque phase à laquelle est connecté le compteur électrique 130. Une valeur de second seuil de courant I_P_Th2 peut être définie pour chaque phase à laquelle est connecté le compteur électrique 130. Une valeur de troisième seuil de courant I_Q_Th1 peut être définie pour chaque phase à laquelle est connecté le compteur électrique 130. Une valeur de quatrième seuil de courant I_Q_Th2 peut être définie pour chaque phase à laquelle est connecté le compteur électrique 130.

Dans une étape 602 suivante, le compteur électrique 130 obtient par mesure une valeur de tension efficace $U_{RMS}$ sur chaque phase à laquelle est connecté le compteur électrique 130, tel que déjà décrit en relation avec la Fig. 5.

Dans une étape 603 suivante, le compteur électrique 130 définit, pour chaque phase à laquelle est connecté le compteur électrique 130, des seuils de puissance en fonction des seuils de courant obtenus à l'étape 601 et en fonction de la valeur de tension efficace $U_{RMS}$ obtenue à l'étape 602.

Dans le premier mode de réalisation, le compteur électrique 130 définit, pour chaque phase à laquelle est connecté le compteur électrique 130, le premier seuil de puissance P_Th et le second seuil de puissance Q_Th.

Dans le second mode de réalisation, le compteur électrique 130 définit, pour chaque phase à laquelle est connecté le compteur électrique 130, le premier seuil de puissance P_Th1, le second seuil de puissance P_Th2, le troisième seuil de puissance Q_Th1 et le quatrième seuil de puissance Q_Th2.

Dans le cadre de l'algorithme de la Fig. 6, chaque valeur de tension efficace $U_{RMS}$ est mesurée, comme dans le cadre de l'algorithme de la Fig. 5. Il est cependant possible d'appliquer dans le cadre de l'algorithme de la Fig. 6 le même principe que dans le cadre de l'algorithme de la Fig. 3, à savoir s'appuyer sur une valeur de tension efficace $U_{RMS}$ fixe pour chaque phase à laquelle est connecté le compteur électrique 130.

Dans une étape 604 suivante, le compteur électrique 130 effectue, pour chaque phase à laquelle est connecté le compteur électrique 130, des mesures de puissance active P et de puissance réactive Q consommées par l'installation électrique supervisée par le compteur électrique 130, comme déjà décrit en relation avec la Fig. 3.

Dans une étape 605 suivante, le compteur électrique 130 vérifie au moins si une première condition est remplie, pour au moins une des phases auxquelles est connecté le compteur électrique 130, pour déclencher ou maintenir le comptage d'énergie active.

Plus précisément, dans le premier mode de réalisation, le compteur électrique 130 vérifie par comparaison si la puissance active mesurée P est supérieure au premier seuil de puissance P_Th, pour au moins une des phases auxquelles est connecté le compteur électrique 130. Si tel est le cas, une étape 606 est effectuée ; sinon, une étape 607 est effectuée.

Plus précisément, dans le second mode de réalisation, le compteur électrique 130 vérifie par comparaison si au moins l'une des premières conditions suivantes est vérifiée :

- condition A : la puissance active mesurée P est supérieure au premier seuil de puissance P_Th1, pour au moins une des phases auxquelles est connecté le compteur électrique 130 ; et
- condition B : la puissance réactive mesurée Q est supérieure au quatrième seuil de puissance Q_Th2, pour au moins une des phases auxquelles est connecté le compteur électrique 130.

Si tel est le cas, l'étape 606 est effectuée ; sinon, l'étape 607 est effectuée.

Dans l'étape 606, le compteur électrique 130 active les opérations de comptage d'énergie active consommée par l'installation électrique supervisée par le compteur électrique 130, et ce, pour toutes les phases auxquelles est connecté le compteur électrique 130. Si les opérations de comptage d'énergie active étaient déjà en cours, le compteur électrique 130 poursuit les opérations de comptage d'énergie active consommée par l'installation électrique supervisée par le compteur électrique 130. Puis, une étape 608 est effectuée.

Dans l'étape 607, le compteur électrique 130 désactive les opérations de comptage d'énergie active consommée par l'installation électrique supervisée par le compteur électrique 130, et ce, pour toutes les phases auxquelles est connecté le compteur électrique 130. Si les opérations de comptage d'énergie active étaient déjà désactivées, le compteur électrique 130 maintient désactivées les opérations de comptage d'énergie active. Puis, l'étape 608 est effectuée.

Dans l'étape 608, le compteur électrique 130 vérifie si au moins une seconde condition est remplie pour déclencher ou maintenir le comptage d'énergie réactive.

Plus précisément, dans le premier mode de réalisation, le compteur électrique 130 vérifie par comparaison si la puissance réactive mesurée Q est supérieure au second seuil de puissance Q_Th, pour au moins une des phases auxquelles est connecté le compteur électrique 130. Si tel est le cas, une étape 609 est effectuée ; sinon, une étape 610 est effectuée.

Plus précisément, dans le second mode de réalisation, le compteur électrique 130 vérifie par comparaison si au moins l'une des secondes conditions suivantes est vérifiée :

- condition C : la puissance active mesurée P est supérieure au second seuil de puissance P_Th2, pour au moins une des phases auxquelles est connecté le compteur électrique 130 ; et
- condition D : la puissance réactive mesurée Q est supérieure au troisième seuil de puissance Q_Th1, pour au moins une des phases auxquelles est connecté le compteur électrique 130.

Si tel est le cas, l'étape 609 est effectuée ; sinon, l'étape 610 est effectuée.

Dans l'étape 609, le compteur électrique 130 active les opérations de comptage d'énergie réactive consommée par l'installation électrique supervisée par le compteur électrique 130, pour toutes les phases auxquelles est connecté le compteur électrique 130. Si les opérations de comptage d'énergie réactive étaient déjà en cours, le compteur électrique 130 poursuit les opérations de comptage d'énergie réactive consommée par l'installation électrique supervisée par le compteur électrique 130. Puis, l'étape 602 est réitérée.

Dans l'étape 610, le compteur électrique 130 désactive les opérations de comptage d'énergie réactive consommée par l'installation électrique supervisée par le compteur électrique 130, pour toutes les phases auxquelles est connecté le compteur électrique 130. Si les opérations de comptage d'énergie réactive étaient déjà désactivées, le compteur électrique 130 maintient désactivées les opérations de comptage d'énergie réactive. Puis, l'étape 602 est réitérée.

Comme dans le cadre des algorithmes des Figs. 3 et 5, l'algorithme de la Fig. 6 fait que le compteur électrique 130 active et désactive sélectivement les opérations de comptage d'énergie active, en fonction au moins d'une comparaison entre la mesure de puissance active et un seuil prédéterminé de puissance, et que le compteur électrique 130 active et désactive sélectivement les opérations de comptage d'énergie réactive, en fonction au moins d'une comparaison entre la mesure de puissance réactive et un autre seuil prédéterminé de puissance.

**Revendications**

1. Procédé de gestion d'opérations de comptage d'énergie active et d'opérations de comptage d'énergie réactive, l'énergie active et l'énergie réactive étant consommées par une installation électrique supervisée par un compteur électrique (110 ; 130), **caractérisé en ce que** le compteur électrique effectue les étapes suivantes :

- effectuer (303 ; 504 ; 604) des mesures de puissance active et de puissance réactive consommées par ladite installation électrique ;
- activer (305 ; 506 ; 606) et désactiver (306 ; 507 ; 607) sélectivement les opérations de comptage d'énergie active, en fonction au moins d'une comparaison entre la mesure de puissance active et un premier seuil prédéterminé de puissance ; et

- activer (308; 509; 609) et désactiver (309; 510; 610) sélectivement les opérations de comptage d'énergie réactive, en fonction au moins d'une comparaison entre la mesure de puissance réactive et un second seuil prédéterminé de puissance.

2. Procédé selon la revendication 1, **caractérisé en ce que** le compteur électrique détermine (503 ; 603) les premier et second seuils de puissance d'après une mesure (502 ; 602) de tension efficace d'alimentation de l'installation électrique.

3. Procédé selon l'une quelconque des revendications 1 et 2, **caractérisé en ce que** le compteur électrique active ou désactive sélectivement les opérations de comptage d'énergie active, aussi en fonction d'une comparaison entre la mesure de puissance réactive et un troisième seuil prédéterminé de puissance.

4. Procédé selon la revendication 3, **caractérisé en ce que** le compteur électrique détermine (503 ; 603) le troisième seuil de puissance d'après une mesure (502 ; 602) de tension efficace d'alimentation de l'installation électrique.

5. Procédé selon l'une quelconque des revendications 1 à 4, **caractérisé en ce que** le compteur électrique active ou désactive sélectivement les opérations de comptage d'énergie réactive, aussi en fonction d'une comparaison entre la mesure de puissance active et un quatrième seuil prédéterminé de puissance.

6. Procédé selon la revendication 5, **caractérisé en ce que** le compteur électrique détermine (503 ; 603) le quatrième seuil de puissance d'après une mesure (502 ; 602) de tension efficace d'alimentation de l'installation électrique.

7. Procédé selon l'une quelconque des revendications 1 à 6, **caractérisé en ce que**, lorsque le compteur électrique (130) est polyphasé, le compteur électrique effectue les étapes suivantes :

- effectuer (604), pour chaque phase à laquelle est connecté le compteur électrique, les mesures de puissance active et de puissance réactive consommées par ladite installation électrique ;
- effectuer une première comparaison, pour chaque phase à laquelle est connecté le compteur électrique, entre la mesure de puissance active et le premier seuil prédéterminé de puissance ;
- effectuer une seconde comparaison, pour chaque phase à laquelle est connecté le compteur électrique, entre la mesure de puissance réactive et le second seuil prédéterminé de puissance ;
- activer (606) et désactiver (607) sélectivement, pour toutes les phases auxquelles est connecté le compteur électrique, les opérations de comptage d'énergie active, en fonction au moins de la première comparaison effectuée pour une dite phase à laquelle est connecté le compteur électrique ; et
- activer (609) et désactiver (610) sélectivement, pour toutes les phases auxquelles est connecté le compteur électrique, les opérations de comptage d'énergie réactive, en fonction au moins de la seconde comparaison effectuée pour une dite phase à laquelle est connecté le compteur électrique.

8. Procédé selon l'une quelconque des revendications 1 à 6, **caractérisé en ce que**, lorsque le compteur électrique (130) est polyphasé, le compteur électrique effectue les étapes suivantes :

- effectuer (504), pour chaque phase à laquelle est connecté le compteur électrique, les mesures de puissance active et de puissance réactive consommées par ladite installation électrique ;
- activer (506) et désactiver (507) sélectivement, pour chaque phase à laquelle est connecté le compteur électrique, les opérations de comptage d'énergie active, en fonction au moins de la comparaison entre la mesure de puissance active et le premier seuil prédéterminé de puissance ; et
- activer (509) et désactiver (510) sélectivement, pour chaque phase à laquelle est connecté le compteur électrique, les opérations de comptage d'énergie réactive, en fonction au moins de la comparaison entre la mesure de puissance réactive et le second seuil prédéterminé de puissance.

9. Procédé selon l'une quelconque des revendications 1 à 8, **caractérisé en ce que**, pour effectuer (303 ; 504 ; 604) des mesures de puissance active et de puissance réactive consommées par ladite installation électrique, le compteur électrique effectue les étapes suivantes :

- obtenir des échantillons de mesure de tension $V_n$ et de mesure de courant $I_n$ ;
- déterminer la puissance active P de la manière suivante :

$$P = \sum V_n \cdot I_n$$

où *n* est un index d'échantillons de mesure ;

- appliquer un filtre passe-bas sur les échantillons de mesure de tension $V_n$ et de mesure de courant $I_n$ pour obtenir respectivement des échantillons de tension filtrés $V'_n$ et des échantillons de courant filtrés $I'_n$ ; et
- déterminer la puissance réactive Q de la manière suivante :

$$Q = \sum V'_{n-N/4} \cdot I'_n$$

où N est un nombre d'échantillons, multiple de quatre, par période fondamentale de signal d'alimentation électrique.

10. Compteur électrique (110; 130) adapté pour gérer des opérations de comptage d'énergie active et des opérations de comptage d'énergie réactive, l'énergie active et l'énergie réactive étant consommées par une installation électrique destinée à être supervisée par le compteur électrique, **caractérisé en ce que** le compteur électrique comporte :

- des moyens adaptés pour effectuer (303 ; 504 ; 604) des mesures de puissance active et de puissance réactive consommées par ladite installation électrique ;
- des moyens adaptés pour activer (305 ; 506 ; 606) et désactiver (306 ; 507 ; 607) sélectivement les opérations de comptage d'énergie active, en fonction au moins d'une comparaison entre la mesure de puissance active et un premier seuil prédéterminé de puissance ; et
- des moyens adaptés pour activer (308 ; 509 ; 609) et désactiver (309 ; 510 ; 610) sélectivement les opérations de comptage d'énergie réactive, en fonction au moins d'une comparaison entre la mesure de puissance réactive et un second seuil prédéterminé de puissance.

11. Compteur électrique selon la revendication 10, **caractérisé en ce que** les moyens adaptés pour effectuer les mesures de puissance active et de puissance réactive utilisent des moyens adaptés pour effectuer des mesures de courant grâce à un montage comportant successivement un capteur de Rogowski, un filtre passe-bas de second ordre et un intégrateur destiné à compenser une fonction de dérivation du capteur de Rogowski.

**Patentansprüche**

1. Verfahren zur Steuerung von Zählvorgängen aktiver Energie und von Zählvorgängen reaktiver Energie, wobei die aktive Energie und die reaktive Energie von einer elektrischen Anlage verbraucht werden, die von einem elektrischen Zähler (110; 130) überwacht wird, **dadurch gekennzeichnet, dass** der elektrische Zähler die folgenden Schritte ausführt:

- Durchführen (303; 504; 604) von Messungen aktiver Leistung und reaktiver Leistung, die von der elektrischen Anlage verbraucht werden;
- selektives Aktivieren (305; 506; 606) und Deaktivieren (306; 507; 607) der Zählvorgänge aktiver Energie in Abhängigkeit zumindest von einem Vergleich zwischen der Messung aktiver Leistung und einem ersten vorbestimmten Leistungsschwellenwert; und
- selektives Aktivieren (308; 509; 609) und Deaktivieren (309; 510; 610) der Zählvorgänge reaktiver Energie in Abhängigkeit zumindest von einem Vergleich zwischen der Messung reaktiver Leistung und einem zweiten vorbestimmten Leistungsschwellenwert.

2. Verfahren nach Anspruch 1, **dadurch gekennzeichnet, dass** der elektrische Zähler den ersten und den zweiten Leistungsschwellenwert gemäß einer Messung (502; 602) effektiver Versorgungsspannung der elektrischen Anlage bestimmt (503; 603).

3. Verfahren nach einem der Ansprüche 1 und 2, **dadurch gekennzeichnet, dass** der elektrische Zähler die Zählvorgänge aktiver Energie auch in Abhängigkeit von einem Vergleich zwischen der Messung reaktiver Leistung und einem dritten vorbestimmten Leistungsschwellenwert selektiv aktiviert oder deaktiviert.

4. Verfahren nach Anspruch 3, **dadurch gekennzeichnet, dass** der elektrische Zähler den dritten Leistungsschwellenwert gemäß einer Messung (502; 602) effektiver Versorgungsspannung der elektrischen Anlage bestimmt (503; 603).

5. Verfahren nach einem der Ansprüche 1 bis 4, **dadurch gekennzeichnet, dass** der elektrische Zähler die Zählvorgänge reaktiver Energie auch in Abhängigkeit von einem Vergleich zwischen der Messung aktiver Leistung und einem vierten vorbestimmten Leistungsschwellenwert selektiv aktiviert oder deaktiviert.

6. Verfahren nach Anspruch 5, **dadurch gekennzeichnet, dass** der elektrische Zähler den vierten Leistungsschwellenwert gemäß einer Messung (502; 602) der effektiven Versorgungsspannung der elektrischen Anlage bestimmt (503; 603).

7. Vorrichtung nach einem der Ansprüche 1 bis 6, **da-**

**durch gekennzeichnet, dass**, wenn der elektrische Zähler (130) mehrphasig ist, der elektrische Zähler die folgenden Schritte ausführt:

- Durchführen (604) der Messungen aktiver Leistung und reaktiver Leistung, die von der elektrischen Anlage verbraucht werden, für jede Phase, mit der der elektrische Zähler verbunden ist;
- Durchführen eines ersten Vergleichs zwischen der Messung aktiver Leistung und dem ersten vorbestimmten Leistungsschwellenwert für jede Phase, mit der der elektrische Zähler verbunden ist;
- Durchführen eines zweiten Vergleichs zwischen der Messung reaktiver Leistung und dem zweiten vorbestimmten Leistungsschwellenwert für jede Phase, mit der der elektrische Zähler verbunden ist;
- selektives Aktivieren (606) und Deaktivieren (607) der Zählvorgänge aktiver Energie für alle Phasen, mit denen der elektrische Zähler verbunden ist, in Abhängigkeit zumindest von dem ersten Vergleich, der für eine Phase durchgeführt wurde, mit der der elektrische Zähler verbunden ist; und
- selektives Aktivieren (609) und Deaktivieren (610) der Zählvorgänge reaktiver Energie für alle Phasen, mit denen der elektrische Zähler verbunden ist, in Abhängigkeit zumindest von dem zweiten Vergleich, der für eine Phase durchgeführt wurde, mit der der elektrische Zähler verbunden ist.

8. Vorrichtung nach einem der Ansprüche 1 bis 6, **dadurch gekennzeichnet, dass**, wenn der elektrische Zähler (130) mehrphasig ist, der elektrische Zähler die folgenden Schritte ausführt:

- Durchführen (504) der Messungen aktiver Leistung und reaktiver Leistung, die von der elektrischen Anlage verbraucht werden, für jede Phase, mit der der elektrische Zähler verbunden ist;
- selektives Aktivieren (506) und Deaktivieren (507) der Zählvorgänge aktiver Energie in Abhängigkeit zumindest von dem Vergleich zwischen der Messung aktiver Leistung und dem ersten vorbestimmten Leistungsschwellenwert für jede Phase, mit der der elektrische Zähler verbunden ist; und
- selektives Aktivieren (509) und Deaktivieren (510) der Zählvorgänge reaktiver Energie in Abhängigkeit zumindest von dem Vergleich zwischen der Messung reaktiver Leistung und dem zweiten vorbestimmten Leistungsschwellenwert für jede Phase, mit der der elektrische Zähler verbunden ist.

9. Verfahren nach einem der Ansprüche 1 bis 8, **dadurch gekennzeichnet, dass** zum Durchführen (303; 504; 604) der Messungen aktiver Leistung und reaktiver Leistung, die von der elektrischen Anlage verbraucht werden, der elektrische Zähler die folgenden Schritte ausführt:

- Erhalten von Messproben der Spannung $V_n$ und des Stroms $I_n$;
- Bestimmen der aktiven Leistung P auf folgende Art und Weise:

$$P = \sum V_n \cdot I_n,$$

wobei n ein Messprobenindex ist;

- Anwenden eines Tiefpassfilters auf die Messproben der Spannung $V_n$ und des Stroms $I_n$, um gefilterte Spannungsproben $V'_n$ bzw. gefilterte Stromproben $I'_n$ zu erhalten; und
- Bestimmen der reaktiven Leistung Q auf folgende Art und Weise:

$$Q = \sum V'_{n-N/4} \cdot I'_n,$$

wobei N eine Probenanzahl, ein Vielfaches von vier, pro Grundperiode des Stromversorgungssignals ist.

10. Elektrischer Zähler (110; 130), der angepasst ist, Zählvorgänge aktiver Energie und Zählvorgänge reaktiver Energie zu steuern, wobei die aktive Energie und die reaktive Energie von einer elektrischen Anlage verbraucht werden, die dazu bestimmt ist, von dem elektrischen Zähler überwacht zu werden, **dadurch gekennzeichnet, dass** der elektrische Zähler Folgendes aufweist:

- Mittel, die angepasst sind, Messungen aktiver Leistung und reaktiver Leistung durchzuführen (303; 504; 604), die von der elektrischen Anlage verbraucht werden;
- Mittel, die angepasst sind, die Zählvorgänge aktiver Energie in Abhängigkeit zumindest von einem Vergleich zwischen der Messung aktiver Leistung und einem ersten vorbestimmten Leistungsschwellenwert selektiv zu aktivieren (305; 506; 606) und zu deaktivieren (306; 507; 607); und
- Mittel, die angepasst sind, in Abhängigkeit zumindest von einem Vergleich zwischen der Messung reaktiver Leistung und einem zweiten vorbestimmten Leistungsschwellenwert die Zählvorgänge reaktiver Energie selektiv zu aktivieren (308; 509; 609) und zu deaktivieren (309; 510; 610).

**11.** Elektrischer Zähler nach Anspruch 10, **dadurch gekennzeichnet, dass** die Mittel, die angepasst sind, die Messungen aktiver Leistung und reaktiver Leistung durchzuführen, Mittel nutzen, die angepasst sind, Strommessungen mithilfe eines Aufbaus durchzuführen, der aufeinanderfolgend einen Rogowski-Sensor, einen Tiefpassfilter zweiter Ordnung und einen Integrator, der bestimmt ist, eine Umgehungsfunktion des Rogowski-Sensors auszugleichen, aufweist.

**Claims**

**1.** Method for managing active power metering operations and reactive power metering operations, the active power and the reactive power being consumed by an electrical installation monitored by an electricity meter (110; 130), **characterized in that** the electricity meter carries out the following steps:

- measuring (303; 504; 604) the active power and reactive power consumed by said electrical installation;
- selectively activating (305; 506; 606) and deactivating (306; 507; 607) the active power metering operations on the basis of at least one comparison between the active power measurement and a first predetermined power threshold; and
- selectively activating (308; 509; 609) and deactivating (309; 510; 610) the reactive power metering operations on the basis of at least one comparison between the reactive power measurement and a second predetermined power threshold.

**2.** Method according to Claim 1, **characterized in that** the electricity meter determines (503; 603) the first and second power thresholds on the basis of a measurement (502; 602) of the effective supply voltage of the electrical installation.

**3.** Method according to either of Claims 1 and 2, **characterized in that** the electricity meter selectively activates or deactivates the active power metering operations also on the basis of a comparison between the reactive power measurement and a third predetermined power threshold.

**4.** Method according to Claim 3, **characterized in that** the electricity meter determines (503; 603) the third power threshold on the basis of a measurement (502; 602) of the effective supply voltage of the electrical installation.

**5.** Method according to any one of Claims 1 to 4, **characterized in that** the electricity meter selectively activates or deactivates the reactive power metering operations also on the basis of a comparison between the active power measurement and a fourth predetermined power threshold.

**6.** Method according to Claim 5, **characterized in that** the electricity meter determines (503; 603) the fourth power threshold on the basis of a measurement (502; 602) of the effective supply voltage of the electrical installation.

**7.** Method according to any one of Claims 1 to 6, **characterized in that** when the electricity meter (130) is polyphase, the electricity meter carries out the following steps:

- measuring (604), for each phase to which the electricity meter is connected, the active power and reactive power consumed by said electrical installation;
- carrying out a first comparison, for each phase to which the electricity meter is connected, between the active power measurement and the first predetermined power threshold;
- carrying out a second comparison, for each phase to which the electricity meter is connected, between the reactive power measurement and the second predetermined power threshold;
- selectively activating (606) and deactivating (607), for all of the phases to which the electricity meter is connected, the active power metering operations on the basis of at least the first comparison carried out for one said phase to which the electricity meter is connected; and
- selectively activating (609) and deactivating (610), for all of the phases to which the electricity meter is connected, the reactive power metering operations on the basis of at least the second comparison carried out for one said phase to which the electricity meter is connected.

**8.** Method according to any one of Claims 1 to 6, **characterized in that**, when the electricity meter (130) is polyphase, the electricity meter carries out the following steps:

- measuring (504), for each phase to which the electricity meter is connected, the active power and reactive power consumed by said electrical installation;
- selectively activating (506) and deactivating (507), for each phase to which the electricity meter is connected, the active power metering operations on the basis of at least the comparison between the active power measurement and the first predetermined power threshold; and
- selectively activating (509) and deactivating (510), for each phase to which the electricity meter is connected, the reactive power metering operations on the basis of at least the comparison between the reactive power measurement and the second predetermined power threshold.

9. Method according to any one of Claims 1 to 8, **characterized in that**, in order to carry out (303; 504; 604) measurements of the active power and reactive power consumed by said electrical installation, the electricity meter carries out the following steps:

- obtaining voltage $V_n$ measurement and current $I_n$ measurement samples;
- determining the active power P in the following manner:

$$P = \sum V_n \cdot I_n$$

where $n$ is a measurement sample index;
- applying a low-pass filter to the voltage $V_n$ measurement and current $I_n$ measurement samples in order to obtain filtered voltage $V'_n$ samples and filtered current $I'_n$ samples, respectively; and
- determining the reactive power Q in the following manner:

$$Q = \sum V'_{n-N/4} \cdot I'_n$$

where N is a number of samples, multiplied by four, per fundamental period of the electrical power supply signal.

10. Electricity meter (110; 130) suitable for managing active power metering operations and reactive power metering operations, the active power and the reactive power being consumed by an electrical installation that is intended to be monitored by the electricity meter, **characterized in that** the electricity meter includes:

- means suitable for measuring (303; 504; 604) the active power and reactive power consumed by said electrical installation;
- means suitable for selectively activating (305; 506; 606) and deactivating (306; 507; 607) the active power metering operations on the basis of at least one comparison between the active power measurement and a first predetermined power threshold; and
- means suitable for selectively activating (308; 509; 609) and deactivating (309; 510; 610) the reactive power metering operations on the basis of at least one comparison between the reactive power measurement and a second predetermined power threshold.

11. Electricity meter according to Claim 10, **characterized in that** the means suitable for measuring the active power and reactive power use means suitable for measuring current by virtue of an assembly including, in succession, a Rogowski sensor, a second-order low-pass filter and an integrator that is intended to compensate for a derivation function of the Rogowski sensor.

Fig. 1A

Fig. 1B

## 110

| | | |
|---|---|---|
| 200<br>CPU | 201<br>RAM | 202<br>ROM |

210

| | | |
|---|---|---|
| 203 | 204 | 205 |

Fig. 2

Obtention de seuils de courant — 301

Définition de seuils de puissance — 302

Obtention d'une valeur de puissance active et d'une valeur de puissance réactive

303

oui — Condition remplie pour puissance active ? — non

304

305

Activation comptage d'énergie active

306

Désactivation comptage d'énergie active

oui — Condition remplie pour puissance réactive ? — non

307

308

Activation comptage d'énergie réactive

309

Désactivation comptage d'énergie réactive

Fig. 3

Fig. 4

Fig. 5

Obtention de seuils de courant
pour chaque phase — 601

Obtention d'une valeur efficace de tension $U_{RMS}$
pour chaque phase — 602

Définition de seuils de puissance
pour chaque phase — 603

Obtention d'une valeur de puissance active et d'une
valeur de puissance réactive, pour chaque phase — 604

Condition remplie pour
puissance active, pour au
moins une phase ?

oui                non

606                607

605

Activation comptage
d'énergie active

Désactivation comptage
d'énergie active

Condition remplie pour
puissance réactive, pour au
moins une phase ?

oui                non

609                610

608

Activation comptage
d'énergie réactive

Désactivation comptage
d'énergie réactive

Fig. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2589581 A1
- EP 2456043 A1
- JP 2008278700 A

**Littérature non-brevet citée dans la description**

- **LEE SEUNGWOO et al.** Automatic Standby Power Management Using Usage Profiling and Prediction. *IEEE Transactions on Human-Machine Systems,* 01 Novembre 2013, vol. 43 (6), 535-546